# FASCICULE DE BREVET EUROPEEN

(11) **EP 1 445 621 B1**
(45) Date de publication et mention de la délivrance du brevet: **14.12.2005**
(21) Numéro de dépôt: 04300046.2
(22) Date de dépôt: 27.01.2004
(51) Int. Cl.: G01R 31/3193, G01R 31/3185

(54) **Test en parallèle de circuits intégrés**
Parallele Prüfung von Intergrierten Schaltungen
Parallel testing of integrated circuits

(30) Priorité: 28.01.2003 FR 0300934
(43) Date de publication de la demande: 11.08.2004
(73) Titulaire: STMicroelectronics S.A., 92120 Montrouge (FR)
(72) Inventeur: Wuidart, Sylvie, 83910 Pourrieres (FR); Zahra, Claude, 13190 Allauch (FR)
(74) Mandataire: de Beaumont, Michel

(56) Documents cités:
- FR-A- 2 733 058
- US-A1- 2002 176 288
- US-B1- 6 466 007

## Description

La présente invention concerne le test des circuits intégrés et, plus particulièrement, le test fonctionnel de puces de circuit intégré au moyen de deux prises de contacts physiques, généralement par des dispositifs de type cartes à pointes. La présente invention concerne plus particulièrement le test de circuits intégrés de transpondeur sans contact destinés à des applications dites sécurisées où des circuits internes à la puce fonctionnent de façon asynchrone par rapport à son environnement extérieur.

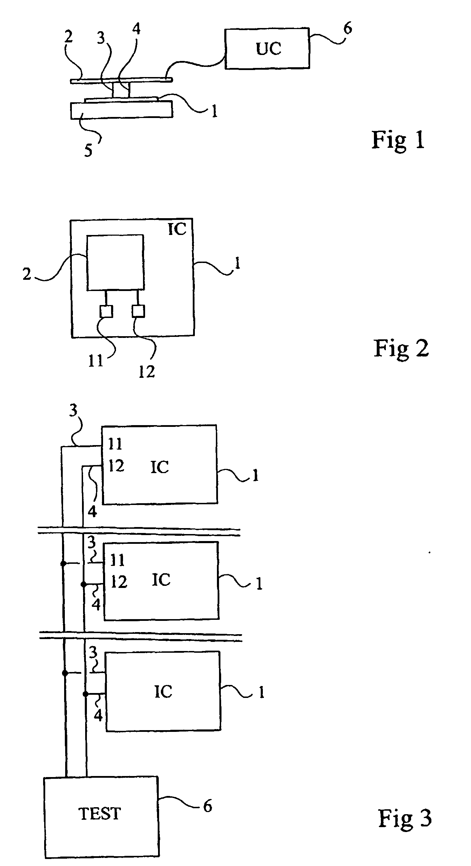

La figure 1 représente, par une vue schématique et sous forme de blocs, un exemple de test classique d'un circuit intégré 1. Un tel testeur comporte un élément 2 de prise de contacts pourvu de deux pointes 3, 4 de connexion à des plots correspondant à la puce de circuit intégré. La puce 1 repose sur un support 5 du testeur et la carte 2 à pointes communique avec une unité centrale 6 (UC) du système de test.

La figure 2 représente, de façon très schématique et sous forme de blocs, une puce 1 du type auquel s'applique la présente invention. La puce 1 comporte une zone 2 comprenant les circuits de traitement liés à l'application et deux plots 11, 12 d'entrée/sortie de cette zone. Les plots 11 et 12 sont plus précisément destinés à être ultérieurement connectés aux extrémités d'un enroulement inductif participant à un circuit résonant, généralement parallèle, dans une application à un transpondeur électromagnétique. Le test fonctionnel que concerne l'invention consiste à tester le circuit avant assemblage avec son circuit résonant.

Le test fonctionnel, dit également test en mode de radiofréquence, s'effectue généralement en utilisant les plots 11 et 12 pour les pointes 3 et 4 du testeur.

Dans des applications dites non sécurisées, on réalise généralement un test fonctionnel en connectant plusieurs circuits intégrés en parallèle. Un tel test s'effectue donc par plaquette entière (Wafer) de circuits intégrés avant découpe.

Dans des applications dites sécurisées, un problème particulier est que le fonctionnement des puces circuits intégrés est volontairement désynchronisé pour ne pas permettre des piratages à partir d'un fonctionnement synchronisé, basé sur une horloge externe à la puce, de quantités secrètes ou algorithmes secrets que contiennent les puces. Les puces répondent donc toutes avec des retards variables et non prédictibles à des commandes reçues sur leurs plots respectifs 11 et 12. Une telle caractéristique des produits sécurisés empêche les tests en parallèle de plusieurs puces, ce qui accroît considérablement les durées de test.

La présente invention vise à proposer une nouvelle méthode de test de puces de circuit intégré qui pallie les inconvénients des solutions connues.

L'invention vise plus particulièrement à proposer un procédé de test de puces de circuit intégré, traitant plusieurs puces identiques en parallèle alors même que ces puces sont destinées à un fonctionnement désynchronisé.

L'invention vise également à proposer une solution compatible avec la structure actuelle des puces de circuit intégré et des testeurs, et notamment qui ne nécessite pas l'accès à un plot supplémentaire par rapport aux deux plots utilisés classiquement.

L'invention vise également à proposer une solution qui soit compatible avec les exploitations classiques faites des résultats de test puce à puce.

Le document US-B-6466007 décrit un système de test pour cartes à puce comprenant un circuit de synchronisation autorisant des signaux de réponse générés à des instants aléatoires après un stimulus.

Le document FR-A-2733058 décrit un procédé et équipement de test automatique en parallèle de composants électroniques, dans lequel des générateurs de temps commandés par une mémoire de programmation de test sont utilisés pour obtenir des signaux de test séparés d'un composant électronique à un autre.

Le document US-A-2002/176288 décrit un procédé et dispositif de test de circuits intégrés utilisant un calcul de signature.

Pour atteindre ces objets et d'autres, la présente invention prévoit un procédé de test en parallèle de plusieurs puces de circuit intégré identiques à fonctionnement asynchrone selon la revendication 1, par l'intermédiaire de deux contacts physiques entre un testeur et chacune des puces, comprenant les étapes suivantes :
émettre côté testeur une première commande de test à destination des puces de circuit intégré ;
exécuter le test de façon désynchronisée par chacune des puces de circuit intégré ;
émettre côté testeur, à l'issue d'un intervalle de temps prédéterminé suivant l'émission de la première commande, une deuxième commande de demande de résultat aux puces de circuit intégré ; et
faire répondre toutes les puces de façon synchrone à réception de ladite deuxième commande.

Selon un mode de mise en oeuvre de la présente invention, l'intervalle de temps prédéterminé est choisi pour être supérieur au temps d'exécution maximum des étapes de test par n'importe quelle puce de circuit intégré.

Selon la présente invention, une puce de circuit intégré recevant ladite première commande se place, après exécution désynchronisée des étapes de test, dans un état prêt à accepter une commande de réponse synchronisée.

Selon un mode de mise en oeuvre de la présente invention, le test est considéré comme négatif dès que la réponse binaire attendue diffère d'un mot de données prédéterminé stocké côté testeur.

L'invention prévoit également un système de test par contact bifilaire d'un ensemble de puces identiques de circuit intégré de façon parallèle selon la revendication 4, comportant une pluralité de paires de contacts physiques destinés à contacter des plots des puces respectives ; et un dispositif de test.

Selon la présente invention, chaque puce de circuit intégré à tester est propre à interpréter au moins une commande de passage en mode de fonctionnement synchrone.

Ces objets, caractéristiques et avantages, ainsi que d'autres de la présente invention seront exposés en détail dans la description suivante de modes de mise en oeuvre et de réalisation particuliers faite à titre non limitatif en relation avec les figures jointes parmi lesquelles :
la figure 1, décrite précédemment représente schématiquement la structure d'un outil de test du type auquel s'applique la présente invention ;
la figure 2, décrite précédemment est une vue schématique de dessus d'une puce de circuit intégré du type auquel se rapporte la présente invention ;
la figure 3 représente, sous forme de blocs, un mode de réalisation d'un système de test en parallèle selon la présente invention ;
la figure 4 illustre un mode de mise en oeuvre du procédé de test selon l'invention ; et
la figure 5 représente les traitements effectués, côté circuit intégré testé.

Les mêmes éléments ont été désignés par les mêmes références aux différentes figures. Pour des raisons de clarté, seuls les étapes et éléments qui sont nécessaires à la compréhension de l'invention ont été représentés aux figures et seront décrits par la suite. En particulier, les structures internes des circuits de la puce de circuit intégré n'ont pas été détaillées et ne font pas l'objet de l'invention. De même, les étapes de test proprement dites n'ont pas été détaillées, l'invention étant compatible avec les tests effectués classiquement.

Une caractéristique de la présente invention est de prévoir, côté puce de circuit intégré, une commande particulière l'autorisant à passer dans un mode de fonctionnement synchronisé, cette commande étant différente d'un signal de synchronisation (horloge) proprement dit.

Une autre caractéristique de l'invention est que l'émission de cette commande particulière vient du testeur et est envoyée en parallèle sur plusieurs puces.

La figure 3 illustre, sous forme de blocs fonctionnels un mode de mise en oeuvre de la présente invention.

Selon l'invention, plusieurs puces 1 sont connectées en parallèle par des paires de pointes 3, 4 respectives à un dispositif 6 de test (TEST). Ainsi, le dispositif 6 comporte autant de contacts (pointes) et d'entrées-sorties qu'il y a de puce à tester en parallèle.

De façon classique, le test que l'on souhaite réaliser sur les puces est un test fonctionnel en mode radiofréquence, c'est-à-dire que le dispositif de test 6 est destiné à émuler la présence d'un circuit résonant connecté aux bornes 11 et 12 de chaque circuit intégré 1.

Bien que cela ne ressorte pas des figures, le test selon l'invention est plus particulièrement destiné à être fait par plaquettes entières (Wafer) c'est-à-dire avant découpe des puces de circuit intégré 1 pour montage soit dans des cartes, soit en boîtiers. Le nombre de puces testées en parallèle ne correspond cependant pas forcément au nombre de puces d'une plaquette.

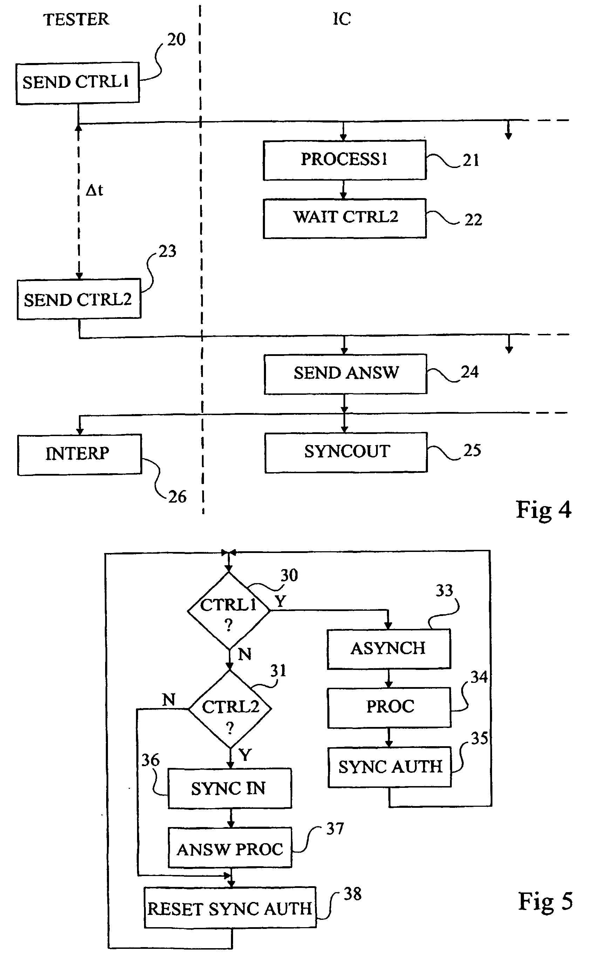

La figure 4 illustre un mode de mise en oeuvre du procédé de test selon la présente invention. Cette figure représente en partie gauche les étapes mises en oeuvre côté testeur (TESTER) et côté droit les étapes mises en oeuvre côté circuit intégré (IC).

Une procédure de test commence selon l'invention par l'envoi d'une commande CTRL1 (bloc 20, SEND CTRL1) en parallèle à toutes les puces de circuit intégré. La commande CTRL1 est interprétable par les différentes puces de circuit intégré comme une commande de début de test incluant, selon l'invention, une demande d'acceptation de fonctionnement synchrone. Côté puce 1, le test proprement dit est effectué (bloc 21, PROCESS1) de façon asynchrone (chaque puce étant cadencée par sa propre horloge) avant que les puces se mettent toutes en attente d'une commande de demande de réponse émanant du testeur (bloc 22, AIT CTRL2).

Le testeur envoie, à destination de toutes puces et après expiration d'un intervalle de temps Δt depuis l'étape 20, une demande de réponse (bloc 23, SEND CTRL2). Cette commande CTRL2 arrive simultanément sur toutes les puces qui répondent alors de façon synchrone (bloc 24, SEND ANSW) à destination du testeur, c'est-à-dire synchronisée sur l'horloge du testeur. Dès qu'elles ont répondu, chacune des puces sort du mode de fonctionnement synchrone (bloc 25, SYNC OUT).

Côté testeur, les réponses reçues de façon synchrone sont interprétées (bloc 26, INTERP). Comme le testeur possède autant d'entrées-sorties qu'il peut tester de puces par lot, les réponses reçues en parallèle sont interprétées pour les différentes puces qui sont identifiables (par exemple, par leur position dans le lot). En pratique, le test d'une puce est considéré comme négatif dès que la réponse binaire attendue diffère d'un mot de données prédéterminé stocké côté testeur. Comme il s'agit d'un test de vérification de fonctionnement, il suffit qu'une des puces ne fonctionne pas correctement pour qu'elle soit déclarée défaillante et subisse un traitement de rejet adéquat.

Le traitement par lot permet de gagner un temps considérable par rapport à un test en série puisqu'il est effectué en parallèle sur toutes les puces du lot. Toutes les puces défectueuses sont identifiées et éliminées comme pour une procédure de rejet classique.

La figure 5 illustre la mise en oeuvre du procédé de test de l'invention côté puce de circuit intégré.

Lorsqu'elle est alimentée, la puce de circuit intégré d'un transpondeur s'attend à recevoir une commande et à l'interpréter. L'alimentation vient classiquement du rayonnement électromagnétique d'une borne de lecture écriture dans le cas d'un transpondeur sans contact. C'est notamment l'un des rôles du circuit résonant qui est de capter cette énergie. En phase de test, l'énergie est fournie, de façon similaire par une porteuse de téléalimentation au moyen des contacts 3 et 4.

Dans sa phase d'attente, la puce teste périodiquement la réception d'une commande CTRL1 (bloc 30, CTRL1 ?). On considère que la sélection du mode test a déjà été effectuée en amont, et on ne se préoccupe donc, par la suite, que des instructions susceptibles de se présenter en mode test.

Si le résultat du test 30 indique la présence de l'instruction CTRL1 de test, la puce de circuit intégré se place, comme par défaut, dans un mode de fonctionnement asynchrone (bloc 33, ASYNCH). Puis exécute la procédure de test prévue sous l'action de la commande CTRL1 (bloc 34, PROC). Enfin, elle se place dans un état propre à accepter une synchronisation de son fonctionnement (bloc 35, SYNC AUTH). La puce se remet alors en attente d'une nouvelle instruction.

Si une commande est reçue mais qu'il ne s'agit pas de l'instruction CTRL1, la puce teste alors s'il s'agit de l'instruction CTRL2 (bloc 31, CTRL2 ?).

En principe, l'instruction reçue après une instruction CTRL1 est l'instruction CTRL2 émise par le testeur (bloc 23, figure 4). Les tests 30 et 31 sont alors respectivement négatif et positif. La puce se place alors dans un mode de fonctionnement synchrone temporairement (bloc 36, SYNC IN) et envoie, de façon synchrone, la réponse ANSW au test de l'instruction CTRL1 effectué (bloc 37, ANSW PROC). Dès qu'elle a émis la réponse ANSW, la puce réinitialise l'autorisation de passage en mode synchrone (bloc 38, RESET SYNC AUTH) et revient en attente d'une instruction suivante.

Si pour une raison quelconque, l'instruction suivant l'instruction CTRL1 n'est pas l'instruction CTRL2, le test 31 est négatif. Cela signifie que l'on est sorti du mode de test et la puce ne se met alors pas en mode synchrone. Elle passe directement au bloc 38, c'est-à-dire qu'elle réinitialise l'autorisation de passage en mode synchrone (bloc 38, RESET SYNC AUTH) avant de revenir en attente d'une instruction suivante. L'instruction est alors traitée en mode asynchrone comme une instruction classique.

De même, si une commande CTRL2 est reçue mais qu'elle ne suit pas une instruction CTRL1, le test 31 sera positif. Toutefois, comme le passage en mode synchrone n'a pas été autorisé par la procédure 35, l'étape 36 sera sans effet. Par conséquent, il n'y aura pas d'envoi synchrone de la réponse de la puce.

Un avantage de l'invention est qu'elle respecte l'exécution sécurisée (en fonctionnement asynchrone) du test proprement dit. En effet, ce n'est qu'après les procédures de test (bloc 34, figure 5), que la puce se dit prête à accepter une commande de fonctionnement synchrone. Cette commande CTRL2, lorsqu'elle est reçue, lui permet d'émettre de façon synchrone la réponse au test.

On se souviendra que, par défaut, tous les traitements à l'intérieur d'une puce du type auquel s'applique l'invention sont des traitements qui s'effectuent de façon désynchronisée, c'est-à-dire sans lien avec une horloge externe. Selon l'invention, ce n'est qu'à l'issue de la commande CTRL2 que la puce commute vers un mode synchrone, c'est-à-dire dépendant de l'horloge externe.

Un avantage de l'invention est qu'elle permet de traiter plusieurs puces en parallèle par la procédure de test, tout en respectant un traitement désynchronisé du test.

La durée du délai Δt d'attente par le testeur entre les émissions des deux commandes est prédéterminée et choisie en fonction du retard maximum possible de traitement de l'instruction de test par les puces à tester.

Un autre avantage de l'invention est qu'elle est parfaitement compatible avec les procédures de test classiques et avec les structures de circuit intégré classiques. En effet, pour sa mise en oeuvre, l'invention ne requiert de la puce de circuit intégré, que la compréhension d'une commande particulière (CTRL2) l'autorisant à passer en mode de fonctionnement synchrone.

Généralement, les puces de circuit intégré à tester auxquelles s'applique la présente invention sont équipées de microcontrôleurs capables d'interpréter différentes commandes. Il suffit alors d'ajouter une commande compréhensible par ces microcontrôleurs.

La mise en oeuvre pratique de l'invention est à la portée de l'homme du métier à partir des indications fonctionnelles données ci-dessus. En particulier, les modifications à apporter aux puces de circuit intégré à tester en fonction des besoins de l'invention comme par exemple l'ajout d'un registre contenant l'indicateur d'autorisation de synchronisation (bloc 35, figure 5) est à la portée de l'homme du métier. De plus, la détermination du nombre de puces par lot est à la portée de l'homme du métier en tenant compte, notamment, du testeur (de ses capacités de traitement en parallèle des différents tests), de la carte à pointes et de la taille des puces.

## Revendications

1. Procédé de test en parallèle de plusieurs puces (1) de circuit intégré identiques à fonctionnement asynchrone, par l'intermédiaire de deux contacts physiques entre un testeur et chacune des puces, **caractérisé en ce qu'**il comprend les étapes suivantes :
émettre (20) côté testeur (6) une première commande de test (CTRL1) à destination des puces de circuit intégré ;
exécuter (21) le test de façon désynchronisée par chacune des puces de circuit intégré ;
émettre (23) côté testeur, à l'issue d'un intervalle de temps prédéterminé suivant l'émission de la première commande, une deuxième commande (CTRL2) de demande de résultat aux puces de circuit intégré ; et
faire répondre (24) de façon binaire toutes les puces de façon synchrone à réception de ladite deuxième commande, chaque puce de circuit intégré recevant ladite première commande se plaçant (35), après exécution désynchronisée des étapes de test (34), dans un état prêt à accepter ladite deuxième commande.

2. Procédé selon la revendication 1, dans lequel l'intervalle de temps prédéterminé est choisi pour être supérieur au temps d'exécution maximum des étapes de test (21) par n'importe quelle puce de circuit intégré.

3. Procédé selon la revendication 1, **caractérisé en ce que** le test est considéré comme négatif dès que la réponse binaire attendue diffère d'un mot de données prédéterminé stocké côté testeur (6).

4. Système de test par contact bifilaire d'un ensemble de puces identiques de circuit intégré de façon parallèle, comportant une pluralité de paires de contacts (3, 4) physiques destinés à contacter des plots (11, 12) des puces respectives, **caractérisé en ce qu'**il comporte un dispositif comprenant des moyens adaptés pour mettre en oeuvre chacune des étapes du procédé selon l'une quelconque des revendications 1 à 3.

## Patentansprüche

1. Verfahren zur parallelen Testung bzw. Prüfung mehrerer identischer integrierter Schaltungschips (1) in asynchroner Betriebsweise, vermittels zweier physischer Kontakte zwischen einer Testvorrichtung und jedem der Chips, **dadurch gekennzeichnet, daß** das Verfahren die folgenden Schritte bzw Stufen umfasst:
- Aussenden (20) von Seiten der Testvorrichtung (6) eines ersten Testbefehls (CTRL 1) mit Bestimmung für die integrierten Schaltungschips;
- Ausführen. (21) des Tests in desynchronisierter Betriebsweise durch jeweils jeden der integrierten Schaltungschips;
- Aussenden (23) von Seiten der Testvorrichtung, am Ende eines vorgegebenen Zeitintervalls nach dem Aussenden des er sten Befehls, eines zweiten Befehls (CTRL 2) zur Ergebnis-Abfrage an die integrierten Schaltungschips ; sowie
- Veranlassen sämtlicher Chips zur Beantwortung (24) in binärer Form in synchroner Betriebsweise, beim Empfang des genannten zweiten Befehls, wobei jeweils jeder den genannten ersten Befehl empfangende integrierte Schaltungschip sich nach desynchronisierter Ausführung der Testverfahrensschritte (34) sich in einen zum Empfang des genannten zweiten Befehls bereiten Zustand versetzt (35)

2. Verfahren nach Anspruch 1, in welchem das vorbestimmte Zeitintervall so gewählt ist, daß es größer als die maximale Ausführungszeit der Testverfahrensschritte (21) durch jeden beliebigen integrierten Schaltungschip ist.

3. Verfahren nach Anspruch 1, **dadurch gekennzeichnet, daß** der Test als negativ betrachtet wird, sobald die erwartete Binärantwort von einem auf Seiten der Testvorrichtung (6) gespeicherten Datenwort verschieden ist.

4. System zur parallelen Testung bzw Prüfung mittels Bifilar-Kontaktierung einer Gruppe identischer integrierter Schaltungschips, wobei das System mehrere Paare von zur Kontaktierung von Kontaktplots (11,12) der betreffenden Chips bestimmten physischen Kontakten (3,4) aufweist, **dadurch gekennzeichnet, daß** das System eine Vorrichtung umfasst, welche zur Ausführung jeder der Verfahrensstufen gemäß einem der Ansprüche 1 bis 3 geeignete Mittel aufweist

## Claims

1. A method for testing in parallel several identical integrated circuit chips (1) with an asynchronous operation, via two physical contacts between a tester and each of the chips, **characterized in that** it comprises the steps of:
transmitting (20) on the tester side (6) a first test control signal (CTRL1) for the integrated circuit chips;
having the test executed (21) in desynchronized fashion by each of the integrated circuit chips;
transmitting (23) on the tester side, after a predetermined time interval following the transmission of the first control signal, a second result request control signal (CTRL2) to the integrated circuit chips; and
having all chips respond (24) in a binary way synchronously upon reception of said second control signal, each integrated circuit chip receiving said first control signal being set (35), after desynchronized execution of the test steps (34), to a state ready to accept a synchronized answer control signal.

2. The method of claim 1, wherein the predetermined time interval is selected to be longer than the maximum execution time of the test steps (21) by any integrated circuit chip.

3. The method of claim 1, wherein the test is considered as being negative as soon as the expected binary answer differs from a predetermined data word stored on the tester side (6) .

4. A system for testing by twin-wire contact a set of identical integrated circuit chips in parallel fashion, comprising a plurality of physical contact pairs (3, 4) intended to contact pads (11, 12) of the respective chips, **characterized in that** it comprises means capable of implementing each step of the method of any of claims 1 to 3.
